# FASCICULE DE BREVET EUROPEEN

(11) **EP 2 682 945 B1**
(45) Date de publication et mention de la délivrance du brevet: **11.03.2015**
(21) Numéro de dépôt: 13354023.7
(22) Date de dépôt: 05.07.2013
(51) Int. Cl.: G21B 1/00, H05H 15/00, C23C 14/06, C23C 14/24, C23C 14/56, C01B 3/00, C01B 4/00, G21B 1/19

(54) **Dispositif de génération de cibles à base d'hydrogène et/ou de deutérium solide**
Vorrichtung zur Erzeugung von Targets auf der Basis von festem Wasserstoff und/oder Deuterium
Device for generating targets made of solid hydrogen and/or deuterium

(30) Priorité: 06.07.2012 FR 1201923
(43) Date de publication de la demande: 08.01.2014
(73) Titulaire: COMMISSARIAT A L'ENERGIE ATOMIQUE ET AUX ENERGIES ALTERNATIVES, 75015 Paris (FR)
(72) Inventeur: Perin, Jean-Paul, F-38180 Seyssins (FR)
(74) Mandataire: Talbot, Alexandre

(56) Documents cités:
- M. C. Fujiwara ET AL: "Characterization of solid hydrogen targets", International Symposium on TRI-PP-95-91 Muon Catalyzed Fusion (jiCF95), 19 juin 1995 (1995-06-19), XP055058559, Dubna Extrait de l'Internet: URL:http://www.researchgate.net/publicatio n/225610509_Characterization_of_solid_hydr ogen_targets/file/79e415110e7d899623.pdf [extrait le 2013-04-04]
- KNOWLES P E ET AL: "A windowless frozen hydrogen target system", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, vol. A368, no. 3, 11 janvier 1996 (1996-01-11), pages 604-610, XP004009919, ISSN: 0168-9002, DOI: 10.1016/0168-9002(95)00659-1
- BULANOV S V ET AL: "FEASIBILITY OF USING LASER ION ACCELERATORS IN PROTON THERAPY", PLASMA PHYSICS REPORTS, AMERICAN INSTITUTE OF PHYSICS, NEW YORK, NY, US, vol. 28, no. 5, 1 mai 2005 (2005-05-01), pages 453-456, XP009071734, ISSN: 1063-780X, DOI: 10.1134/1.1478534
- WANG ET AL: "Acceleration of laser-driven ion bunch from double-layer thin foils", PHYSICS OF PLASMAS, AMERICAN INSTITUTE OF PHYSICS, WOODBURY, NY, US, vol. 19, no. 5, 23 mai 2012 (2012-05-23), pages 53110-1, XP009168530, ISSN: 1070-664X

## Description

### Domaine technique de l'invention

L'invention concerne un dispositif de réalisation de cibles d'hydrogène et/ou de deutérium solide en continu et à des températures cryogéniques.

### État de la technique

Les récents progrès réalisés par les lasers de fortes puissances permettent d'envisager leur utilisation dans plusieurs domaines, notamment dans des domaines exploitant un faisceau de protons. À titre d'exemple, la proton-thérapie est une technique particulière de radiothérapie visant à détruire des cellules cancéreuses en les irradiant avec un faisceau de protons. Les protons peuvent être accélérés en focalisant un laser pulsé de haute intensité sur une cible comportant de l'hydrogène et/ou du deutérium solide pure, à une cadence de l'ordre de 10 Hz.

Il est donc intéressant de disposer d'un système réalisant en continu un film d'hydrogène et/ou de deutérium solide, ayant une fine épaisseur (1 à 10 µm), déposé sur un ruban en or ou en aluminium. En utilisant ce type de ruban, les protons provenant, principalement du film d'hydrogène et/ou de deutérium solide, peuvent être accélérés par le champ électrique intense généré par l'interaction d'un laser intense avec le ruban en or ou en aluminium.

La formation de films d'hydrogène et/ou de deutérium solide est, généralement, réalisée sur des feuilles en or ou en argent. L'article [« Experimental setup for X-ray spectroscopy of muonic atoms formed from implanted ions in solid hydrogen » - P. Strasser et al. - Nuclear Instruments and Methods in Physics Research A, 460 (2001), pp. 451 - 456] décrit un spectromètre à rayons X émis par des atomes muoniques. Dans ce dispositif, les atomes muoniques sont générés par implantation ionique dans un film en hydrogène solide. Le spectromètre comporte une enceinte cryogénique comportant un support d'une feuille d'argent et un diffuseur d'un mélange gazeux à base d'hydrogène et de deutérium. La pression et le volume du mélange gazeux, introduit dans le diffuseur, produisent une distribution dosée du mélange gazeux sur la feuille d'argent. Le maintien de la feuille d'argent à une température de 3 K, et la distribution dosée du mélange gazeux d'hydrogène et de deutérium permettent ainsi la formation d'un film solide d'hydrogène sur la feuille d'argent.

L'interaction d'un laser avec des cibles solides peut être mis à profit dans d'autres domaines, par exemple dans la lithographie par ultraviolet extrême (13,5 nm de longueur d'onde). Dans l'article [« Laser-Plasma Extreme Ultraviolet Source Incorporating a Cryogenic Xe Target » - S. Amano - Recent Advances in Nanofabrication Techniques and Applications, Décembre (2011), pp.353 - 368], un plasma LPP généré par un laser (LPP pour l'acronyme anglais de Laser-Produced Plasma) constitue la source du faisceau ultraviolet extrême. Cet article décrit un dispositif utilisant du Xe comme cible solide pour la création du plasma LPP. En effet, le Xe permet d'obtenir une forte émission autour de 13,5 nm, et d'éviter le dépôt de résidus puisque le Xe est un gaz inerte. Le dispositif comporte un système comprenant un tambour cylindrique en cuivre rempli d'azote liquide destiné à refroidir la surface externe du tambour. Le Xe en phase gazeuse est ensuite injecté sur la surface externe du tambour cylindrique en rotation. Ainsi, le Xe en phase gazeuse se condense pour former un film solide en Xe d'une épaisseur allant de 300 à 500 µm.

### Objet de l'invention

Dans certaines applications, il existe un besoin de fournir un dispositif de dépôt, en continu, d'un film d'hydrogène et/ou de deutérium solide sur un ruban, facile à réaliser, et à utiliser.

On tend à satisfaire ce besoin en prévoyant un dispositif de dépôt en continu d'un film solide d'hydrogène ou de deutérium, ou d'un mélange des deux comportant :
- une cellule munie de première et seconde ouvertures, et d'un orifice d'introduction de l'hydrogène et/ou du deutérium en phase gazeuse, le débit du gaz introduit dans la cellule étant ajusté via une vanne de régulation ;
- un ruban traversant la cellule au moyen des première et seconde ouvertures ;
- un organe de déplacement du ruban configuré pour déplacer le ruban dans la cellule de la première ouverture vers la seconde ouverture ;
- un dispositif de pompage configuré pour placer un volume de la cellule, traversé par le ruban, à une première pression ;
- un premier échangeur de chaleur configuré pour maintenir le ruban dans ledit volume de la cellule à une première température cryogénique ;
- un circuit de commande du dispositif de pompage et de la vanne de régulation, configuré pour régler la première pression à une valeur supérieure à la valeur de la pression de vapeur saturante de l'hydrogène ou du deutérium ou du mélange, à la première température cryogénique, de manière à condenser, respectivement, un film d'hydrogène et/ou de deutérium solide sur le ruban en mouvement dans ledit volume de la cellule.

On prévoit également un procédé de dépôt en continu d'un film solide d'hydrogène ou de deutérium comportant les étapes suivantes :
- faire défiler un ruban dans une cellule depuis une première ouverture vers une seconde ouverture ;
- injecter un gaz constitué par de l'hydrogène ou du deutérium ou un mélange des deux dans la cellule, le ruban étant maintenu dans un volume de la cellule à une première température cryogénique, et le gaz étant à une première pression, dans la cellule, ladite première pression est réglée à une première valeur inférieure à la pression de vapeur saturante du gaz à la première température ;
- élever la première pression du gaz dans ledit volume de la cellule depuis la première valeur jusqu'à une deuxième valeur de pression supérieure à la pression de vapeur saturante du gaz à la première température.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente schématiquement un dispositif de réalisation, en continu, d'un film en hydrogène ou en deutérium solide sur un ruban ;
- la figure 2 représente un autre mode de réalisation d'un dispositif de réalisation, en continu, d'un film en hydrogène ou en deutérium solide sur un ruban
- la figure 3 représente le diagramme de phase de l'hydrogène.

### Description de modes particuliers de réalisation

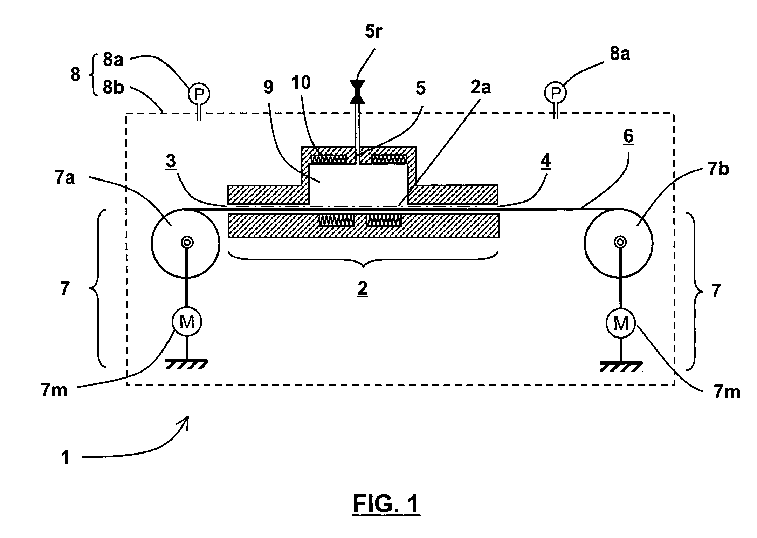

Comme représenté à la figure 1, un dispositif 1 de dépôt en continu d'un film solide d'hydrogène ou de deutérium ou d'un mélange des deux, comporte une cellule 2 s'étendant le long d'un axe longitudinal 2a. La cellule 2 est munie de première et seconde ouvertures 3 et 4 et d'un orifice d'introduction 5 de l'hydrogène ou du deutérium ou d'un mélange des deux, en phase gazeuse. La première ouverture 3 est avantageusement disposée au niveau d'une première extrémité de la cellule 2, et la seconde ouverture 4 est avantageusement disposée au niveau d'une seconde extrémité opposée à la première extrémité selon l'axe longitudinal 2a. En outre, le dispositif 1 comporte une vanne de régulation 5r destinée à ajuster le débit du gaz introduit dans la cellule 2.

Le dispositif 1 comporte également un ruban 6 sur lequel un film solide d'hydrogène et/ou de deutérium sera déposé avantageusement en continu. Le ruban 6 est un ruban métallique, et il est préférentiellement à base d'or ou d'aluminium. Par dépôt en continu d'un film sur le ruban 6 dans la cellule 2, on entend que le dispositif 1 permet le dépôt d'un film sur le ruban 6 alors qu'il est en mouvement à l'intérieur de la cellule 2. Le ruban 6 se déplace dans la cellule 2 en la traversant au moyen des première 3 et seconde 4 ouvertures. Par ailleurs, ce déplacement n'exclut pas un arrêt provisoire du ruban 6 dans la cellule 2.

Le dispositif 1 comporte en outre un organe de déplacement 7 configuré pour provoquer le déplacement du ruban 6 dans la cellule 2 de la première ouverture 3 vers la seconde ouverture 4. L'organe de déplacement 7 peut comporter des premier 7a et second 7b tourets fixes, autour desquels le ruban 6 peut être enroulé. Le premier touret 7a peut être disposé au niveau de la première ouverture 3. Ainsi, le deuxième touret 7b peut être disposé au niveau de la seconde ouverture 4 de manière à ce que la cellule 2 soit interposée entre le premier 7a et le deuxième 7b touret. L'emplacement des premier 7a et second 7b tourets est choisi de manière à pouvoir déplacer le ruban 6 dans la cellule 2. L'organe de déplacement 7 peut comporter un moteur 7m destiné à faire tourner le second touret 7b autour de son axe de manière à faire dérouler le ruban 6 du premier touret 7a en l'enroulant autour du second touret 7b. Avantageusement, le moteur 7m permet également de faire tourner le premier touret 7a et de réaliser le déplacement du ruban 6 dans le sens inverse : de la seconde ouverture 4 vers la première ouverture 3. Un autre moteur peut également être associé au premier touret 7a.

De manière générale, la condensation d'un gaz à des températures cryogéniques, nécessite un réglage précis de la pression et de la température du gaz à condenser. Or, selon la configuration de la cellule 2, la vanne de régulation 5r ne peut, elle seule, maintenir une pression constante du gaz introduit dans la cellule 2. En effet, le gaz introduit via l'orifice 5, peut fuir de la cellule 2 à travers les première et seconde ouvertures 3 et 4. De ce fait, pour réguler la pression du gaz à condenser, le dispositif 1 comporte en outre un dispositif de pompage 8 configuré pour placer un volume 9 de la cellule 2 à une première pression P1. Ledit volume 9 est défini dans la cellule 2 et il est traversé par le ruban 6. Le dispositif de pompage peut comporter une ou plusieurs pompes 8a et une enceinte étanche 8b contenant la cellule 2 et le ruban 6. Par ailleurs, le dispositif de pompage 8 permet d'éviter toute condensation parasite du gaz en dehors dudit volume 9, en aspirant le gaz fuyant de la cellule 2. La cellule 2 comporte également un premier échangeur de chaleur 10 configuré pour maintenir le ruban 6 dans ledit volume 9 de la cellule à une première température cryogénique T1. Par températures cryogéniques, on entend des températures inférieures à environ 120 K. Le premier échangeur de chaleur 10 est préférentiellement disposé dans les parois de la cellule 2, de manière à être en contact avec les molécules du gaz introduit dans la cellule 2. Pour des raisons de simplification, le premier échangeur de chaleur 10 désignera également, dans la suite du texte, la partie de la cellule 2 définissant ledit volume 9 de la cellule. Le contact entre les molécules du gaz et le premier échangeur de chaleur 10 permet un réglage facile de la température du gaz compris dans ledit volume 9. L'échangeur de chaleur 10 est préférentiellement commandé par un thermostat. Grâce au phénomène d'échange thermique moléculaire entre le gaz et le ruban 6, l'échangeur de chaleur 10 permet ainsi de maintenir le ruban 6 et le gaz introduit dans ledit volume 9 de la cellule à la première température cryogénique T1. Pour un dépôt en continu d'un film d'hydrogène solide sur le ruban 6, le gaz introduit est un gaz d'hydrogène et la première température T1 est préférentiellement égale à 7 K. Pour un dépôt en continu d'un film de deutérium solide sur le ruban 6, le gaz introduit est un gaz de deutérium et la première température T1 est préférentiellement égale à 12 K.

Le dispositif 1 est en mesure de définir la température du gaz et du ruban 6 dans la cellule 2 grâce au premier échangeur de chaleur 10. Afin de définir également la pression, le dispositif 1 comporte un circuit de commande du dispositif de pompage 8 et de la vanne de régulation 5r. Ledit circuit de commande est configuré pour régler la première pression P1 à une valeur P1c supérieure à la valeur de la pression de vapeur saturante Ps du matériau à déposer, à la première température cryogénique T1, de manière à condenser respectivement un film solide d'hydrogène ou de deutérium ou d'un mélange des deux, sur le ruban 6 en mouvement dans ledit volume 9 de la cellule. Avantageusement, le réglage de la première pression P1, par le circuit de commande, dépend également de la vitesse de déplacement du ruban 6 dans ledit volume 9 de la cellule et de l'épaisseur du film solide qu'on cherche à condenser sur le ruban 6.

Le dispositif 1 permet de déposer un film en hydrogène ou en deutérium solide sur un ruban métallique en mouvement. Le ruban métallique peut alors être bombardé par un faisceau laser, préférentiellement pulsé, et générer ainsi un faisceau de protons, grâce à l'interaction du laser avec le ruban métallique. Afin de générer le faisceau de protons, le laser interagit directement avec le ruban métallique pour générer un plasma d'or ou d'aluminium à forte densité électronique. Ainsi, le film en hydrogène ou en deutérium solide est préférentiellement disposé uniquement sur une des deux faces principales du ruban. Le laser bombarde alors la face dépourvue de film d'hydrogène et/ou de deutérium solide. Le champ électrique intense généré par l'interaction laser métal, permet d'accélérer des protons localisés au niveau de la face du ruban comportant le film solide d'hydrogène et/ou de deutérium.

Le dispositif 1 selon le premier mode de réalisation permet de condenser un film d'hydrogène et/ou de deutérium solide sur les deux faces principales du ruban 6 dans ledit volume 9 de la cellule 2. Dès lors, pour préparer le ruban 6 à une éventuelle interaction avec un faisceau laser, le dispositif 1 peut comporter des moyens destinés à éliminer le film condensé sur une des deux faces principales du ruban 6. À titre d'exemple, le dispositif 1 peut comporter une racle, non représentée à la figure 1, disposée en aval de la cellule 2, selon le sens de déplacement du ruban 6. Ladite racle est conformée et placée de manière à éliminer le film en hydrogène ou en deutérium solide condensé sur une des deux faces principales du ruban 6.

Le dépôt en continu, d'un film en hydrogène ou en deutérium solide sur un ruban métallique permet de faciliter une génération continue d'un faisceau de protons. De manière avantageuse, le dispositif peut être configuré de manière à ce que la vitesse de déplacement du ruban 6 soit choisie en fonction de la fréquence du laser pulsé bombardant le ruban 6. À titre d'exemple, en utilisant des premier 7a et second 7b tourets d'un diamètre de 40 mm, et une vitesse de déplacement du ruban 6 de 5 mm/s le dispositif 1 a permis la production, en continu pendant 24 heures, d'un ruban comportant un film d'hydrogène solide d'une épaisseur d'environ 5 µm.

Préférentiellement, le premier échangeur de chaleur 10 est configuré pour être en contact avec une face principale 6a du ruban 6. À titre d'exemple, les éléments permettant le transfert thermique avec le premier échangeur de chaleur 10 peuvent être disposés en saillie par rapport aux parois de la cellule 2, de manière à être en contact avec le ruban 6 lorsque ce dernier traverse la cellule 2. Le contact entre le premier échangeur de chaleur 10 et le ruban 6, permet un transfert thermique direct entre ces deux éléments. Ainsi, la définition de la température du ruban 6 est plus précise et le transfert thermique est plus rapide en comparaison d'un transfert thermique réalisé par l'intermédiaire du gaz d'hydrogène ou de deutérium compris entre le premier échangeur thermique 10 et le ruban 6. Par ailleurs, le premier échangeur de chaleur 10 permet également un transfert thermique vers les molécules du gaz contenues dans ledit volume 9.

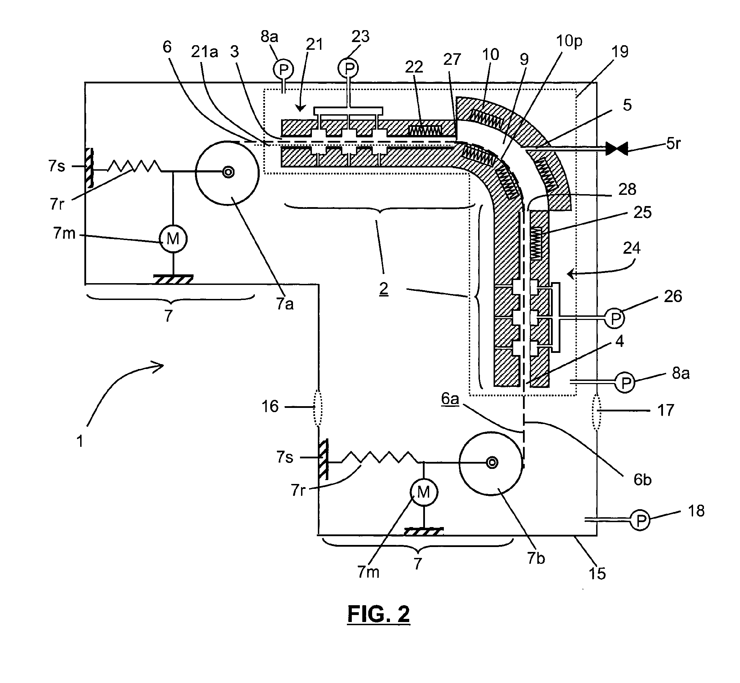

Selon un second mode de réalisation illustré à la figure 2, le premier échangeur de chaleur 10 et la cellule 2 sont configurés pour être en contact avec la face principale 6a du ruban 6, dans ledit volume 9 de la cellule, de manière à avoir une condensation de l'hydrogène ou du deutérium solide sur la face opposée 6b du ruban 6. Le dispositif 1 de la figure 2 comprend des éléments semblables à ceux illustrés à la figure 1, désignés par des mêmes références. On retrouve notamment, l'organe de déplacement 7, le ruban 6, et la cellule 2 munie des première 3 et seconde 4 ouvertures et comportant le volume 9 traversé par le ruban 6. On retrouve également, le premier échangeur de chaleur 10 et le dispositif de pompage 8. De préférence, le premier échangeur de chaleur 10 comporte une paroi interne 10p ayant la forme d'une courbe convexe. Cette paroi interne 10p est conformée pour être en contact avec la face principale 6a du ruban 6 lors du passage de ce dernier dans ledit volume 9 de la cellule. Le dispositif 1 de dépôt en continu selon ce mode de réalisation permet de réaliser un transfert thermique efficace entre le premier échangeur de chaleur 10 et le ruban 6. Le dispositif 1 permet, par ailleurs, de déposer un film d'hydrogène et/ou de deutérium solide sur la face principale 6a du ruban métallique 6, en laissant découverte la face opposée 6b du ruban 6, destinée à interagir avec un faisceau laser.

De manière avantageuse, l'organe de déplacement 7 est connecté mécaniquement à un support fixe 7s par l'intermédiaire d'au moins un ressort 7r de manière à fixer la tension du ruban 6, et la pression d'appui du ruban 6 sur le premier échangeur de chaleur 10 dans ledit volume 9 de la cellule. Le ressort 7r peut ainsi régler la pression d'appui du ruban 6 sur la paroi interne 10p du premier échangeur de chaleur 10, ce qui permet d'améliorer le transfert thermique de l'échangeur de chaleur vers le ruban 6. Le ressort 7r permet également de maintenir une tension fixe du ruban 6 lors de son déplacement dans la cellule 2, notamment lors de son déroulement et enroulement autour des tourets 7a et 7b. Le maintien d'une tension choisie permet alors d'éviter un étirement excessif du ruban 6 pouvant engendrer une déformation ou pire encore une rupture du ruban métallique 6.

Afin de prendre en compte une éventuelle interaction entre un faisceau laser et la face opposée 6b du ruban 6, le dispositif 1 comporte avantageusement un cryostat 15 étanche, à l'intérieure duquel se trouve la cellule 2 et le ruban 6. Le cryostat 15 est conformé de manière à comporter un premier hublot 16 configuré pour laisser passer un faisceau laser incident bombardant le ruban 6, et un deuxième hublot 17 configuré pour laisser passer le faisceau de protons ou de neutrons transmis par le ruban 6. À titre d'exemple, le premier hublot 16 peut être à base de Saphir, et le deuxième hublot 17 peut être à base de Mylar. Pour réaliser une interaction efficace uniquement entre le faisceau laser et le ruban 6, le cryostat 15 comporte également une pompe additionnelle 18 configurée pour créer un vide dans le cryostat étanche 15. Le vide créé au sein du cryostat permet d'éviter toute condensation parasite du gaz sur la face opposée 6b du ruban métallique 6, pouvant perturber l'interaction du laser avec le ruban métallique 6.

Pour une meilleure isolation thermique entre la cellule 2 et l'organe de déplacement 7, le dispositif 1 peut comporter un écran thermique interposé entre ces deux éléments. Autrement dit, le dispositif 1 comporte avantageusement, un écran thermique 19 séparant l'organe de déplacement 7 et la cellule 2. En effet, l'organe de déplacement 7 comporte des pièces mécaniques maintenues à 300 K qui génèrent des apports de chaleur par rayonnement. En l'absence d'un écran thermique, ces apports de chaleur peuvent perturber la stabilité thermique de la cellule 2, et de ce fait la condensation du gaz sur le ruban 6.

De manière avantageuse, la cellule 2 comporte un conduit amont 21 disposé entre la première ouverture 3 et le premier échangeur thermique 10, et s'étendant le long d'un axe longitudinal 21a. Le conduit amont 21 est conformé de manière à être traversé par le ruban 6 lors du déplacement de ce dernier dans la cellule 2. Ainsi, le ruban 6 traverse respectivement, la première ouverture 3, le conduit amont 21, puis le premier échangeur de chaleur 10 lorsque le ruban 6 se déplace dans la cellule 2 de la première ouverture 3 vers la seconde ouverture 4. De préférence, le ruban 6 traverse le conduit amont 21 selon une direction confondue avec l'axe longitudinal 21a. Le conduit amont 21 est connecté audit volume 9 de la cellule de manière à former un premier orifice de sortie 27 du gaz non condensé sur le ruban 6. De manière avantageuse, la cellule 2 comporte également un deuxième échangeur de chaleur 22, disposé préférentiellement dans les parois du conduit amont 21. Le deuxième échangeur de chaleur 22 est configuré pour maintenir le ruban 6 dans le conduit amont 21 à une deuxième température T2 supérieure à la première température T1. La deuxième température T2 est fixée de manière à maintenir le gaz d'hydrogène ou de deutérium, introduit dans la cellule 2, en phase gazeuse dans le conduit amont 21.

Le conduit amont 21 permet de préparer thermiquement le ruban 6 avant son passage dans ledit volume 9 de la cellule. En effet, le ruban 6 est initialement enroulé autour des premier et second tourets 7a et 7b, qui fonctionnent à une température plus élevée, par exemple à une température proche de la température ambiante (environ 300 K). Le deuxième échangeur de chaleur 22 du conduit amont 21 permet d'abaisser et de maintenir la température du ruban 6 à la deuxième température T2, préférentiellement proche de la première température T1. Le conduit amont 21 permet ainsi au premier échangeur de chaleur 10 de maintenir de manière rapide et précise la température du ruban 6 dans ledit volume 9, ce qui permet d'améliorer l'efficacité de la condensation de l'hydrogène et/ou du deutérium solide sur le ruban 6.

De manière préférentielle, l'organe de déplacement 7 est configuré pour que le ruban 6 soit dépourvu de contact avec le deuxième échangeur de chaleur 22 dans le conduit amont 21. Le ruban 6 étant en contact avec le premier échangeur de chaleur 10, cette disposition permet d'éviter un frottement supplémentaire entre le ruban 6 et la cellule 2. En effet, des frottements répétitifs peuvent engendrer une usure et une fatigue mécaniques du ruban métallique 6. Le transfert thermique entre le deuxième échangeur de chaleur 22 et le ruban 6 est alors réalisé par échange thermique moléculaire. Ce dernier est effectué en exploitant la circulation du gaz d'hydrogène et/ou de deutérium non condensé, depuis le premier orifice de sortie 27 vers la première ouverture 3, via le conduit amont 21. Cette circulation du gaz est rendue possible grâce au dispositif de pompage 8 qui participe à la régulation de la pression du gaz à condenser dans la cellule 2 et en particulier dans ledit volume 9 de la cellule. Pour un meilleur contrôle de cette pression, le dispositif de pompage 8 comporte avantageusement une première pompe 23 configurée pour aspirer le gaz excédentaire non condensé qui circule dans le conduit amont 21 en aval du deuxième échangeur de chaleur 22. La première pompe 23 est, de préférence, disposée entre la première ouverture 3 et le deuxième échangeur de chaleur 22. La première pompe 23 est connectée au conduit amont 21 via un ou plusieurs orifices conformés dans une zone des parois internes du conduit amont 21. De manière avantageuse, ladite zone des parois internes est constituée par des chicanes, améliorant ainsi l'aérodynamique du gaz lors de son aspiration par la première pompe 23.

Avantageusement, la cellule 2 comporte un conduit aval 24 semblable au conduit amont 21. Le conduit aval 24 est disposé entre le premier échangeur thermique 10 et la seconde ouverture 4, et il est conformé de manière à être traversé par le ruban 6 lors du déplacement de ce dernier dans la cellule 2. Le conduit aval 24 est connecté audit volume 9 de la cellule de manière à former un second orifice de sortie 28 du gaz non condensé sur le ruban 6. De manière avantageuse, la cellule 2 comporte également un troisième échangeur de chaleur 25, disposé préférentiellement dans les parois du conduit aval 24. Le troisième échangeur de chaleur 25, configuré pour maintenir le ruban 6 dans le conduit aval 24 à une troisième température T3 supérieure à la première température T1. La troisième température T3 est fixée de manière à maintenir le gaz d'hydrogène ou de deutérium, introduit dans la cellule 2, en phase gazeuse dans le conduit aval 24. De préférence, les deuxième T2 et troisième T3 températures sont sensiblement égales.

Le conduit aval 24 permet avantageusement d'arrêter la condensation d'hydrogène et/ou de deutérium solide sur le ruban 6, tout en gardant des conditions thermodynamiques compatibles avec un maintien du film d'hydrogène et/ou de deutérium à l'état solide sur le ruban 6.

De manière préférentielle, l'organe de déplacement 7 est configuré pour que le ruban 6 soit dépourvu de contact avec le troisième échangeur de chaleur 25 dans le conduit aval 24. Le transfert thermique entre le troisième échangeur de chaleur 25 et le ruban 6 est réalisé par échange thermique moléculaire. Ce dernier est effectué en exploitant la circulation du gaz d'hydrogène et/ou de deutérium non condensé, entre le second orifice de sortie 28 et la seconde ouverture 4, via le conduit aval 24. Pour un meilleur contrôle de la pression du gaz dans la cellule 2, le dispositif de pompage 8 comporte avantageusement une seconde pompe 26 configurée pour aspirer le gaz excédentaire non condensé qui circule dans le conduit aval 24. La seconde pompe 26 est, de préférence, disposée entre la seconde ouverture 4 et le troisième échangeur de chaleur 25. La seconde pompe 26 est connectée au conduit aval 24 via un ou plusieurs orifices conformés dans une zone des parois internes du conduit aval 24. Ladite zone des parois internes est préférentiellement constituée par des chicanes.

Selon un mode particulier de mise en oeuvre d'un dépôt en continu d'un film d'hydrogène et/ou de deutérium solide sur un ruban métallique, le procédé de dépôt utilise un des dispositifs illustrés aux figures 1 et 2. Le procédé de dépôt en continu selon l'invention, comporte une étape permettant de faire défiler un ruban métallique 6 dans une cellule 2 depuis une première ouverture 3 vers une seconde ouverture 4. Le dépôt du film d'hydrogène et/ou de deutérium solide est réalisé à très basse température, par exemple à une température comprise entre 5 K et 20 K, préférentiellement entre 7 K et 12 K. Le ruban 6 se déplace, préférentiellement, de manière continue à l'intérieur de la cellule 2, soit dans un sens soit dans l'autre, pour prévenir tout collage du ruban 6 sur les pièces froides du dispositif de dépôt 1.

Le procédé de dépôt comporte, en outre, une étape d'injection d'un gaz constitué par de l'hydrogène ou du deutérium dans la cellule 2. Lors de cette étape d'injection du gaz, le ruban 6 est maintenu dans un volume 9 de la cellule à une première température cryogénique T1. Par ailleurs, le gaz est maintenu à une première pression P1 dans la cellule 2. Lors de cette étape d'injection, la première pression P1 est réglée de manière à avoir une première valeur P1i inférieure à la pression de vapeur saturante Ps du gaz à la première température T1.

Afin de condenser le gaz sur le ruban métallique 6, le procédé de dépôt comporte une étape d'élévation de la première pression P1 du gaz dans ledit volume 9. En effet, après l'injection du gaz dans ledit volume 9 de la cellule, la première pression P1 du gaz est augmentée depuis la première valeur P1i jusqu'à une deuxième valeur de pression P1c. La deuxième valeur de pression P1c du gaz dans ledit volume est choisie de manière à être supérieure à la pression de vapeur saturante Ps du gaz à condenser, à la première température T1.

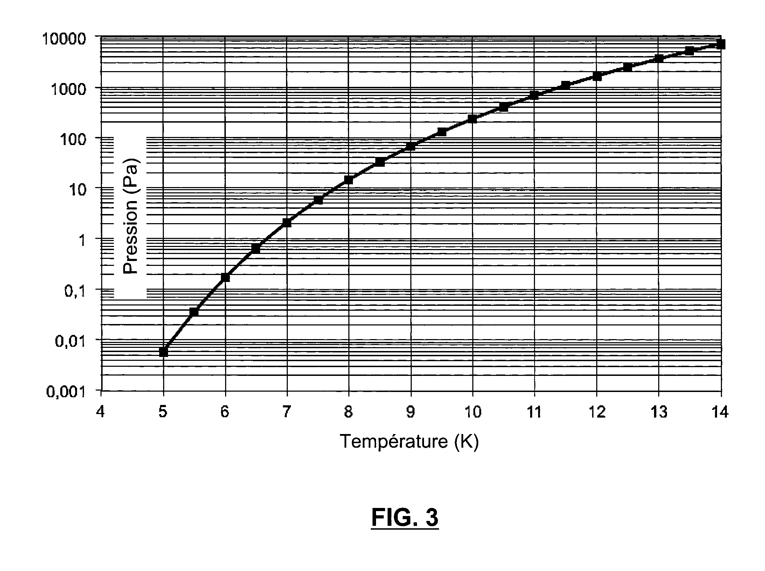

La figure 3 illustre le tracé de la courbe de saturation du gaz d'hydrogène, représentant la variation de la pression de vapeur saturante Ps(T) en fonction de la température. Selon cette courbe de saturation, la pression de vapeur saturante de l'hydrogène à une température de 7 K, est égale à environ 2 Pa. Pour un dépôt d'hydrogène solide, en fixant la première température T1 à 7 K, la première pression P1 doit être inférieure à 2 Pa, lors de l'étape d'injection. En effet, le maintien de la première pression P1 du gaz dans la cellule 2, par exemple à 1 Pa, le gaz d'hydrogène reste en phase gazeuse, pendant l'étape d'injection. Pour réaliser la condensation de l'hydrogène, il suffit d'augmenter la pression de l'hydrogène dans la cellule, notamment dans ledit volume, de 1 Pa à une deuxième pression P2 supérieure à 2 Pa, par exemple à 10 Pa. Selon la courbe de saturation de la figure 3, lors de cette élévation de pression, le gaz d'hydrogène passe de la phase gazeuse à la phase solide. De préférence, les deuxième 22 et troisième 25 échangeurs de chaleur sont configurés de manière à maintenir la température dans les conduits amont et aval 21 et 24 égale à environ 8 K. En effet, selon le tracé de la courbe de saturation illustré à la figure 3, l'hydrogène reste en phase gazeuse lors de l'étape d'injection (P1 = 1 Pa, et T2 = T3 = 8 K) ainsi que lors de l'étape de condensation (P1 = 10 Pa, et T2 = T3 = 8K).

Le procédé de dépôt en continu selon l'invention, permet avantageusement de relâcher la contrainte sur le paramètre température, pour se focaliser uniquement sur le paramètre « pression du gaz » lors de la condensation. En effet, la stabilisation de la température du ruban et du gaz à condenser, peut s'avérer plus délicate que le réglage de la pression du gaz dans la cellule de condensation. Ainsi, le procédé selon l'invention permet de faciliter la condensation en continu d'un film d'hydrogène et/ou de deutérium solide sur un ruban métallique.

Selon un mode préférentiel de mise en oeuvre, le procédé de dépôt en continu utilise le dispositif 1 illustré à la figure 2. Préférentiellement, le procédé comporte une première étape où la pompe additionnelle 18 met le cryostat 15 sous vide. À titre d'exemple, la pompe additionnelle 18 maintient la pression au sein du cryostat 15 à environ 10⁻⁴ Pa. Ensuite, l'organe de déplacement 7 est configuré pour imposer un mouvement de va-et-vient du ruban métallique 6. En même temps, le premier échangeur de chaleur 10 maintient le ruban 6 à la première température T1. Le gaz à condenser, est alors injecté dans ledit volume 9 de la cellule. L'injection du gaz dans ledit volume est réalisée après la stabilisation de la température du ruban à la première température T1. Le dispositif de pompage 8, comportant les deux pompes 8a, et éventuellement les première et seconde pompes 23 et 26 est alors réglé pour maintenir le gaz dans la cellule 2 à une première pression P1, ayant une première valeur P1i inférieure à la pression de vapeur saturante Ps du gaz à condenser à la première température T1. De ce fait, le gaz ne se condense pas sur le ruban métallique 6, et reste en phase gazeuse. Grâce au dispositif de pompage 8, le gaz à condenser ne fuit pas depuis la cellule 2 vers le cryostat 15, ce qui permet de maintenir le cryostat 15 à une pression constante et de préserver la qualité du vide dans le cryostat 15. De plus, dans le cas où une infime quantité de gaz échappe à l'aspiration, la pompe additionnelle 18 évacue cette quantité de gaz pour éviter toute condensation parasite du gaz en dehors de la cellule 2.

L'injection du gaz dans la cellule 2 et le réglage des deuxième 22 et troisième 25 échangeurs de chaleur, permettent de maintenir le ruban 6 à une deuxième T2 et une troisième T3 températures, respectivement dans le conduit amont 21 et le conduit aval 24. En effet, ces échangeurs de chaleur mettent à profit la circulation du gaz entre la ledit volume 9 et les conduits amont et aval 21 et 24 pour refroidir le ruban par échange thermique moléculaire. Les deuxième et troisième températures T2 et T3, sont choisies de manière à être proches de la première température T1, et à maintenir le gaz à condenser en phase gazeuse dans les conduits amont et aval 21 et 24.

Lorsque la température du ruban 6 et du gaz dans ledit volume est stabilisée (égale à T1), le circuit de commande du dispositif de pompage 8 et de la vanne de régulation 5r, est configuré pour augmenter la pression du gaz dans ledit volume 9 de la première valeur P1i à une deuxième valeur de pression P1c supérieure à la pression de vapeur saturante Ps du gaz à condenser à la première température T1. Cette augmentation de la pression permet alors de déposer un film solide d'hydrogène et/ou de deutérium sur le ruban 6 en mouvement dans ledit volume 9 de la cellule. Le circuit de commande ajuste la première pression P1 en fonction du gaz considéré (hydrogène ou deutérium), la vitesse de déplacement du ruban 6 dans ledit volume 9 et de l'épaisseur de la couche à déposer sur le ruban 6.

Avantageusement, le procédé de dépôt comporte une étape finale consistant à réchauffer la cellule 2 et le cryostat 15, par exemple à une température de 25 K. Ce réchauffage permet d'évacuer tous les condensats indésirables dans la cellule 2 et dans le cryostat 15 afin de préparer le dispositif de dépôt 1 à une nouvelle condensation d'hydrogène et/ou de deutérium sur le ruban métallique 6.

## Revendications

1. Dispositif de dépôt en continu (1) d'un film solide d'hydrogène ou de deutérium ou d'un mélange des deux, **caractérisé en ce qu'il** comporte :
- une cellule (2) munie de première et seconde ouvertures (3, 4), et d'un orifice d'introduction (5) de l'hydrogène ou du deutérium ou du mélange en phase gazeuse, le débit du gaz introduit dans la cellule (2) étant ajusté via une vanne de régulation (5r) ;
- un ruban (6) traversant la cellule (2) au moyen des première et seconde (3, 4) ouvertures ;
- un organe de déplacement (7) du ruban (6) configuré pour déplacer le ruban (6) dans la cellule (2) de la première ouverture (3) vers la seconde ouverture (4) ;
- un dispositif de pompage (8) configuré pour placer un volume (9) de la cellule, traversé par le ruban (6), à une première pression (P1) ;
- un premier échangeur de chaleur (10) configuré pour maintenir le ruban (6) dans ledit volume (9) de la cellule à une première température cryogénique (T1) ;
- un circuit de commande du dispositif de pompage (8) et de la vanne de régulation (5r), configuré pour régler la première pression (P1) à une valeur (P1c) supérieure à la valeur de la pression de vapeur saturante (Ps) de l'hydrogène ou du deutérium ou du mélange, à la première température cryogénique (T1), de manière à condenser un film solide d'hydrogène ou de deutérium ou d'un mélange des deux sur le ruban (6) en mouvement dans ledit volume (9) de la cellule.

2. Dispositif selon la revendication 1, **caractérisé en ce que** le premier échangeur de chaleur (10) est configuré pour être en contact avec une face principale (6a) du ruban (6).

3. Dispositif selon la revendication 2, **caractérisé en ce que** le premier échangeur de chaleur (10) et la cellule (2) sont configurés pour être en contact avec la face principale (6a) du ruban (6) dans ledit volume (9) de la cellule, de manière à avoir une condensation de l'hydrogène ou du deutérium ou du mélange des deux sur la face opposée (6b) uniquement.

4. Dispositif selon la revendication 3, **caractérisé en ce que** l'organe de déplacement (7) est connecté mécaniquement à un support fixe (7s) par l'intermédiaire d'au moins un ressort (7r) de manière à fixer, la tension du ruban (6), et la pression d'appui du ruban (6) sur le premier échangeur de chaleur (10) dans ledit volume (9) de la cellule.

5. Dispositif selon l'une quelconque des revendications 1 à 4, **caractérisé en ce que** la cellule (2) comporte :
- un conduit amont (21) disposé entre la première ouverture (3) et le premier échangeur de chaleur (10), le conduit amont (21) étant traversé par le ruban (6) ;
- un deuxième échangeur de chaleur (22) configuré pour maintenir le ruban (6) dans le conduit amont (21) à une deuxième température (T2) supérieure à la première température (T1), la deuxième température (T2) étant fixée de manière à maintenir l'hydrogène ou le deutérium ou le mélange des deux en phase gazeuse dans le conduit amont (21).

6. Dispositif selon la revendication 5, **caractérisé en ce que** l'organe de déplacement (7) est configuré pour que le ruban (6) soit dépourvu de contact avec le deuxième échangeur de chaleur (22), le conduit amont (21) étant connecté audit volume (9) de la cellule de manière à former un premier orifice de sortie (27) du gaz non condensé sur le ruban (6).

7. Dispositif selon la revendication 6, **caractérisé en ce que** le dispositif de pompage comporte une première pompe (23) configuré pour aspirer le gaz non condensé circulant dans le conduit amont (21).

8. Dispositif selon l'une quelconque des revendications 1 à 4, **caractérisé en ce que** la cellule (2) comporte :
- un conduit aval (24) disposé entre la seconde ouverture (4) et le premier échangeur de chaleur (10), le conduit aval (24) étant traversé par le ruban (6) ;
- un troisième échangeur de chaleur (25) configuré pour maintenir le ruban (6) dans le conduit aval (25) à une troisième température (T3) supérieure à la première température cryogénique (T1), la troisième température (T3) étant fixée de manière à maintenir l'hydrogène ou le deutérium en phase gazeuse dans le conduit aval (24).

9. Dispositif selon la revendication 8, **caractérisé en ce que** l'organe de déplacement (7) est configuré pour que le ruban (6) soit dépourvu de contact avec le troisième échangeur de chaleur (25), le conduit aval (24) étant connecté audit volume (9) de la cellule de manière à former un second orifice de sortie (28) du gaz non condensé sur le ruban (6).

10. Dispositif selon la revendication 9, **caractérisé en ce que** le dispositif de pompage comporte une deuxième pompe (26) configurée pour aspirer le gaz non condensé circulant dans le conduit aval (24).

11. Dispositif selon l'une quelconque des revendications 1 à 10, **caractérisé en ce qu'il** comporte un écran thermique (19) séparant l'organe de déplacement (7) et la cellule (2).

12. Dispositif selon la revendication 1, **caractérisé en ce qu'il** comporte un cryostat (15) étanche, à l'intérieure duquel se trouve la cellule (2) et le ruban (6), le cryostat (15) comportant :
- un premier hublot (16) configuré pour laisser passer un faisceau laser incident bombardant le ruban (6) ;
- un deuxième hublot (17) configuré pour laisser passer le faisceau de protons ou de neutrons transmis par le ruban (6) ;
- une pompe additionnelle (18) configurée pour créer un vide dans le cryostat étanche (15).

13. Procédé de dépôt en continu d'un film solide d'hydrogène ou de deutérium ou d'un mélange des deux utilisant un dispositif selon l'une quelconque des revendications 1 à 12, **caractérisé en ce qu'**il comporte les étapes suivantes :
- faire défiler un ruban (6) dans une cellule (2) depuis une première ouverture (3) vers une seconde ouverture (4) ;
- injecter un gaz constitué par de l'hydrogène ou du deutérium ou d'un mélange des deux dans la cellule (2), le ruban (6) étant maintenu dans un volume (9) de la cellule à une première température cryogénique (T1), et le gaz étant à une première pression (P1) dans la cellule (2), ladite première pression (P1) étant réglée à une première valeur (P1i) inférieure à la pression de vapeur saturante (Ps) du gaz à la première température (T1) ;
- élever la première pression (P1) du gaz dans ledit volume (9) de la cellule depuis la première valeur (P1i) jusqu'à une deuxième valeur de pression (P1c) supérieure à la pression de vapeur saturante (Ps) du gaz à la première température (T1).

## Patentansprüche

1. Vorrichtung zum kontinuierlichen Abscheiden (1) eines festen Films aus Wasserstoff oder aus Deuterium oder aus einer Mischung von beiden, **dadurch gekennzeichnet, dass** sie umfasst:
- eine Zelle (2), die mit einer ersten und einer zweiten Öffnung (3, 4) und mit einer Öffnung zum Einleiten (5) des Wasserstoffs oder des Deuteriums oder der Mischung in gasförmiger Phase versehen ist, wobei die Menge des in die Zelle (2) eingeleiteten Gases über eine Regelventil (5r) eingestellt wird;
- ein Band (6), das die Zelle (2) mittels der ersten und der zweiten (3, 4) Öffnung durchquert;
- ein Organ zum Bewegen (7) des Bandes (6), das dazu ausgelegt ist, das Band (6) in der Zelle (2) von der ersten Öffnung (3) zu der zweiten Öffnung (4) zu bewegen;
- eine Pumpvorrichtung (8), die dazu ausgelegt ist, einen Raum (9) der Zelle, der von dem Band (6) durchquert wird, auf einen ersten Druck (P1) zu bringen;
- einen ersten Wärmetauscher (10), der dazu ausgelegt ist, das Band (6) in dem Raum (9) der Zelle auf einer ersten kryogenen Temperatur (T1) zu halten;
- einen Kreis zum Steuern der Pumpvorrichtung (8) und des Regelventils (5r), der dazu ausgelegt ist, den ersten Druck (P1) auf einen Wert (P1c) oberhalb des Wertes des Sättigungsdampfdrucks (Ps) des Wasserstoffs oder des Deuteriums oder der Mischung, bei der ersten kryogenen Temperatur (T1) einzustellen, um einen festen Film aus Wasserstoff oder aus Deuterium oder aus einer Mischung von beiden auf das in dem Raum (9) der Zelle in Bewegung befindliche Band (6) aufzukondensieren.

2. Vorrichtung nach Anspruch 1, **dadurch gekennzeichnet, dass** der erste Wärmetauscher (10) dazu ausgelegt ist, mit einer Hauptseite (6a) des Bandes (6) in Kontakt zu sein.

3. Vorrichtung nach Anspruch 2, **dadurch gekennzeichnet, dass** der erste Wärmetauscher (10) und die Zelle (2) dazu ausgelegt sind, mit der Hauptseite (6a) des Bandes (6) in dem Raum (9) der Zelle in Kontakt zu sein, um eine Kondensation des Wasserstoffs oder des Deuteriums oder der Mischung von beiden lediglich auf der gegenüberliegenden Seite (6b) zu haben.

4. Vorrichtung nach Anspruch 3, **dadurch gekennzeichnet, dass** das Bewegungsorgan (7) mittels wenigstens einer Feder (7r) mit einem festen Träger (7s) mechanisch verbunden ist, um die Spannung des Bandes (6) und den Auflagedruck des Bandes (6) auf dem ersten Wärmetauscher (10) in dem Raum (9) der Zelle festzulegen.

5. Vorrichtung nach einem der Ansprüche 1 bis 4, **dadurch gekennzeichnet, dass** die Zelle (2) umfasst:
- eine stromaufwärtige Leitung (21), die zwischen der ersten Öffnung (3) und dem ersten Wärmetauscher (10) angeordnet ist, wobei die stromaufwärtige Leitung (21) von dem Band (6) durchquert wird;
- einen zweiten Wärmetauscher (22), der dazu ausgelegt ist, das Band (6) in der stromaufwärtigen Leitung (21) auf einer zweiten Temperatur (T2) oberhalb der ersten Temperatur (T1) zu halten, wobei die zweite Temperatur (T2) derart festgelegt ist, dass der Wasserstoff oder das Deuterium oder die Mischung von beiden in der stromaufwärtigen Leitung (21) in gasförmiger Phase gehalten wird.

6. Vorrichtung nach Anspruch 5, **dadurch gekennzeichnet, dass** das Bewegungsorgan (7) dazu ausgelegt ist, dass das Band (6) keinen Kontakt mit dem zweiten Wärmetauscher (22) hat, wobei die stromaufwärtige Leitung (21) mit dem Raum (9) der Zelle verbunden ist, um eine erste Austrittsöffnung (27) des nicht auf dem Band (6) kondensierten Gases zu bilden.

7. Vorrichtung nach Anspruch 6, **dadurch gekennzeichnet, dass** die Pumpvorrichtung eine erste Pumpe (23) umfasst, die dazu ausgelegt ist, das in der stromaufwärtigen Leitung (21) zirkulierende nicht kondensierte Gas abzusaugen.

8. Vorrichtung nach einem der Ansprüche 1 bis 4, **dadurch gekennzeichnet, dass** die Zelle (2) umfaßt:
- eine stromabwärtige Leitung (24), die zwischen der zweiten Öffnung (4) und dem ersten Wärmetauscher (10) angeordnet ist, wobei die stromabwärtige Leitung (24) von dem Band (6) durchquert wird;
- einen dritten Wärmetauscher (25), der dazu ausgelegt ist, das Band (6) in der stromabwärtigen Leitung (24) auf einer dritten Temperatur (T3) oberhalb der ersten kryogenen Temperatur (T1) zu halten, wobei die dritte Temperatur (T3) derart festgelegt ist, dass der Wasserstoffoder das Deuterium in der stromabwärtigen Leitung (24) in gasförmiger Phase gehalten wird.

9. Vorrichtung nach Anspruch 8, **dadurch gekennzeichnet, dass** das Bewegungsorgan (7) dazu ausgelegt ist, dass das Band (6) keinen Kontakt mit dem dritten Wärmetauscher (25) hat, wobei die stromabwärtige Leitung (24) mit dem Raum (9) der Zelle verbunden ist, um eine zweite Austrittsöffnung (28) des nicht auf dem Band (6) kondensierten Gases zu bilden.

10. Vorrichtung nach Anspruch 9, **dadurch gekennzeichnet, dass** die Pumpvorrichtung eine zweite Pumpe (26) umfasst, die dazu ausgelegt ist, das in der stromabwärtigen Leitung (24) zirkulierende nicht kondensierte Gas abzusaugen.

11. Vorrichtung nach einem der Ansprüche 1 bis 10, **dadurch gekennzeichnet, dass** sie einen Hitzeschild (19), der das Bewegungsorgan (7) und die Zelle (2) trennt, umfasst.

12. Vorrichtung nach Anspruch 1, **dadurch gekennzeichnet, dass** sie ein dichtes Kryostat (15) umfasst, in dem sich die Zelle (2) und das Band (6) befinden, wobei das Kryostat (15) umfasst:
- ein erstes Fenster (16), das dazu ausgelegt ist, einen ankommenden, das Band (6) beschießenden Laserstrahl hindurch zu lassen;
- ein zweites Fenster (17), das dazu ausgelegt ist, den durch das Band (6) übertragenen Protonen- oder Neutronenstrahl hindurch zu lassen;
- eine zusätzliche Pumpe (18), die dazu ausgelegt ist, in dem dichten Kryostat (15) ein Vakuum zu erzeugen.

13. Verfahren zum kontinuierlichen Abscheiden eines festen Films aus Wasserstoff oder aus Deuterium oder aus einer Mischung von beiden, das eine Vorrichtung nach einem der Ansprüche 1 bis 12 verwendet, **dadurch gekennzeichnet, dass** es die folgenden Schritte umfasst:
- ein Band (6) in einer Zelle (2) von einer ersten Öffnung (3) zu einer zweiten Öffnung (4) laufen lassen;
- ein durch Wasserstoff oder Deuterium oder eine Mischung von beiden gebildetes Gas in die Zelle (2) einleiten, wobei das Band (6) in einem Raum (9) der Zelle auf einer ersten kryogenen Temperatur (T1) gehalten wird und wobei das Gas sich auf einem ersten Druck (P1) in der Zelle (2) befindet, wobei der erste Druck (P1) auf einen ersten Wert (P1i) unterhalb des Sättigungsdampfdrucks (Ps) des Gases bei der ersten Temperatur (T1) eingestellt wird;
- den ersten Druck (P1) des Gases in dem Raum (9) der Zelle von dem ersten Wert (P1i) bis auf einen zweiten Druckwert (P1c) oberhalb des Sättigungsdampfdrucks (Ps) des Gases bei der ersten Temperatur (T1) erhöhen.

## Claims

1. A device for performing continuous deposition (1) of a film of solid hydrogen or deuterium, or of a mixture of the two, **characterized in that** it comprises:
- a cell (2) provided with first and second openings (3, 4), and with an inlet opening (5) of the hydrogen and/or deuterium or of the mixture in gas phase into the cell, the flowrate of the gas inlet to the cell (2) being adjusted via a control valve (5r);
- a strip (6) passing through the cell (2) by means of the first and second openings (3, 4);
- movement means (7) of the strip (6) configured to move the strip (6) in the cell (2) from the first opening (3) to the second opening (4);
- a pumping device (8) configured to place a volume (9) of the cell, through which the strip (6) passes, at a first pressure (P1);
- a first heat exchanger (10) configured to maintain the strip (6) in said volume (9) of the cell at a first cryogenic temperature (T1);
- a control circuit of the pumping device (8) and of the control valve (5r) configured to adjust the first pressure (P1) to a higher value (P1c) than the value of the saturated steam pressure (Ps) of the hydrogen or deuterium or of a mixture of the two at the first cryogenic temperature (T1), so as to respectively condense a solid film of hydrogen and/or deuterium or of a mixture of the two on the strip (6) in movement in said volume (9) of the cell.

2. The device according to claim 1, **characterized in that** the first heat exchanger (10) is configured to be in contact with a main surface (6a) of the strip (6).

3. The device according to claim 2, **characterized in that** the first heat exchanger (10) and the cell (2) are configured to be in contact with the main surface (6a) of the strip (6) in said volume (9) of the cell, so as to achieve condensation of the hydrogen or deuterium or of the mixture of the two on the opposite surface (6b) only.

4. The device according to claim 3, **characterized in that** the movement means (7) are mechanically connected to a fixed support (7s) by means of at least one spring (7r) so as to fix the tension of the strip (6) and the contact pressure of the strip (6) on the first heat exchanger (10) in said volume (9) of the cell.

5. The device according to any one of claims 1 to 4, **characterized in that** the cell (2) comprises:
- an upstream duct (21) arranged between the first opening (3) and the first heat exchanger (10), the strip (6) passing through the upstream duct (21);
- a second heat exchanger (22) configured to maintain the strip (6) in the upstream duct (21) at a second temperature (T2) that is higher than the first temperature (T1), the second temperature (T2) being fixed so as to maintain the hydrogen or deuterium or the mixture of the two in gas phase in the upstream duct (21).

6. The device according to claim 5, **characterized in that** the movement means (7) are configured for the strip (6) to be devoid of contact with the second heat exchanger (22), the upstream duct (21) being connected to said volume (9) of the cell so as to form a first outlet opening (27) of the non-condensed gas on the strip (6).

7. The device according to claim 6, **characterized in that** the pumping device comprises a first pump (23) configured to perform suction of the non-condensed gas flowing in the upstream duct (21).

8. The device according to any one of claims 1 to 4, **characterized in that** the cell (2) comprises:
- a downstream duct (24) arranged between the second opening (4) and the first heat exchanger (10), the strip (6) passing through the downstream duct (24);
- a third heat exchanger (25) configured to maintain the strip (6) in the downstream duct (25) at a third temperature (T3) that is higher than the first cryogenic temperature (T1), the third temperature (T3) being fixed so as to maintain the hydrogen or deuterium in gas phase in the downstream duct (24).

9. The device according to claim 8, **characterized in that** the movement means (7) are configured for the strip (6) to be devoid of contact with the third heat exchanger (25), the downstream duct (24) being connected to said volume (9) of the cell so as to form a second outlet opening (28) of the non-condensed gas on the strip (6).

10. The device according to claim 9, **characterized in that** the pumping device comprises a second pump (26) configured to perform suction of the non-condensed gas flowing in the downstream duct (24).

11. The device according to any one of claims 1 to 10, **characterized in that** it comprises a heat shield (19) separating the movement means (7) and the cell (2).

12. The device according to claim 1, **characterized in that** it comprises a tightly sealed cryostat (15) inside which the cell (2) and strip (6) are located, the cryostat (15) comprising;
- a first window (16) configured to let an incident laser beam bombarding the strip (6) pass;
- a second window (17) configured to let the proton or neutron beam transmitted by the strip (6) pass;
- an additional pump (18) configured to create a vacuum in the sealed cryostat (15).

13. A method for performing continuous deposition of a solid film of hydrogen or deuterium or of a mixture of the two using a device according to any one of claims 1 to 12 **characterized in that** it comprises the following steps:
- running a strip (6) through a cell (2) from a first opening (3) to a second opening (4);
- injecting a gas formed by hydrogen or deuterium or a mixture of the two into the cell (2), the strip (6) being maintained in a volume (9) of the cell at a first cryogenic temperature (T1), and the gas being at a first pressure (P1) in the cell (2), said first pressure (P1) being adjusted to a first value (P1 i) lower than the saturated steam pressure (Ps) of the gas at the first temperature (T1);
- increasing the first pressure (P1) of the gas in said volume (9) of the cell from the first value (P1i) to a second pressure value (P1c) that is higher than the saturated steam pressure (Ps) of the gas at the first temperature (T1).
